# EUROPEAN PATENT SPECIFICATION

(11) **EP 2 848 092 B1**
(45) Date of publication and mention of the grant of the patent: **06.07.2016**
(21) Application number: 13728002.0
(22) Date of filing: 29.04.2013
(51) Int. Cl.: H01L 25/075, H01L 33/64, H05B 33/08

(54) **METHOD FOR INCREASING HEAT CONDUCTIVITY IN SYSTEMS THAT USE HIGH POWER DENSITY LEDS**
VERFAHREN ZUR ERHÖHUNG DER WÄRMELEITFÄHIGKEIT IN SYSTEMEN UNTER VERWENDUNG VON LEDS MIT HOHER LEISTUNGSDICHTE
PROCÉDÉ D'AUGMENTATION DE LA CONDUCTIVITÉ THERMIQUE DANS DES SYSTÈMES UTILISANT DES LED À DENSITÉ DE PUISSANCE ÉLEVÉE

(30) Priority: 02.05.2012 IT MO20120116
(43) Date of publication of application: 18.03.2015
(73) Proprietor: Printabled S.R.L., 42027 Montecchio Emilia (RE) (IT)
(72) Inventor: DAL PONT, Massimiliano, I-42124 Reggio Emilia (IT)
(74) Representative: Molinari, Marinella
(86) International application number: PCT/IB2013/053386
(87) International publication number: WO 2013/164756

(56) References cited:
- WO-A1-2008/073794
- WO-A1-2011/138257

## Description

The invention relates to a method for improving the dissipation of heat produced in systems that use LEDs with high power density, for example devices for drying inks in printing apparatuses that use UV LEDs.

High power density LEDs are defined as LEDs with power density above 50W/cm².

In the aforesaid systems the problem of dissipating the heat produced by the LEDs during operation is critical, inasmuch as the temperature of the system must be prevented from increasing excessively, which could irremediably damage the LEDs.

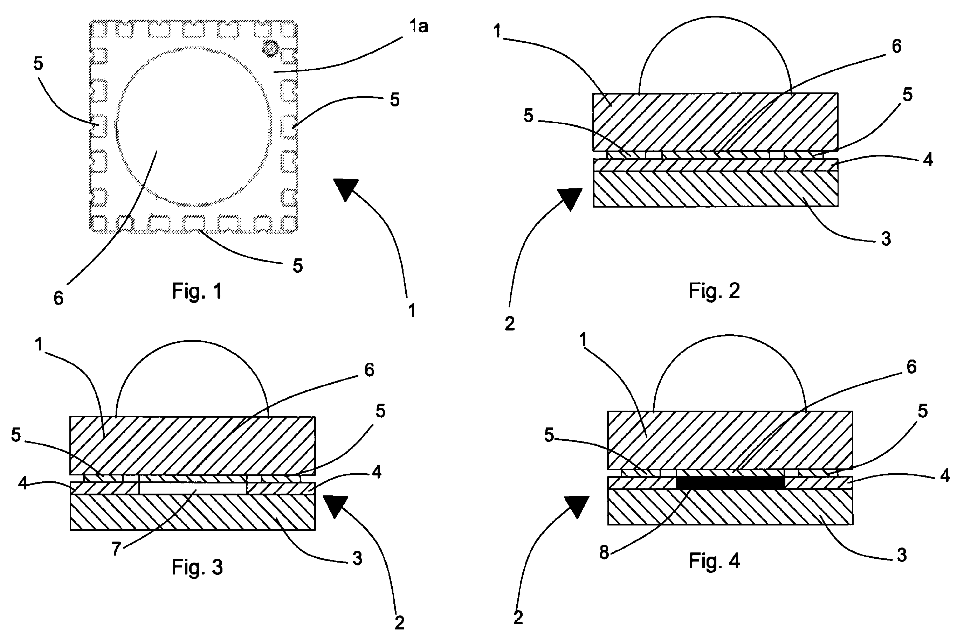

In known prior-art systems, as shown in Figure 2, the LEDs 1 are mounted on a printed circuit board 2 that comprises a thermally conductive substrate 3, made, for example, of aluminium or copper, having, for example, a thickness comprised between about 1 and 2 mm. The substrate 3 is covered by a layer 4 of electrically insulating material, having, for example, a thickness of about 100 µm, on which tracks of electrically conductive material (not shown) are obtained to which the electrical contacts 5 of the LEDs 1 are connected.

The heat produced by the LEDs during operation is dispersed through the substrate 3, which can be cooled by a suitable cooling device (not shown).

The presence of the layer 4 of electrically insulating material nevertheless hinders the dissipation of heat because even electrically insulating materials that have the best thermal conductivity features have too high thermal resistance such as to cause a temperature increase at the junction between the LED 1 and the layer of insulating material 4 of even 40-50 °C and beyond, which entails a significant increase in the steady-state operating temperature of the LEDs, with a consequent risk of rapid damage to the LEDs, or anyway a significant decrease in the life of the LEDs.

The present invention proposes to provide a method for improving the dissipation of the heat in systems that use LEDs with high power density, in such a manner that the steady-state operating temperature of the LEDs can be lowered simply and effectively.

The task that is the basis of the present invention is achieved with a method according to claim 1.

Owing to the invention, heat transmission from the LEDs to the substrate 3 of the printed circuit board 2 is improved significantly, so that the heat produced by the operation of the LEDs can be dissipated much more rapidly and efficiently through the substrate 3, thus significantly lowering the steady-state operating temperature of the LEDs.

One manner of implementing the invention will now be disclosed by way of purely and non-limiting example, with reference to the attached drawings, in which:
Figure 1 is a bottom view of a LED having a high specific power;
Figure 2 is a cross section of the LED in Figure 1 mounted on a printed circuit board, according to the state of the art;
Figure 3 is a cross section like the one in Figure 2 that illustrates a first step of the method according to the present invention;
Figure 4 is a cross section like the one in Figure 2 that illustrates a second step of the method according to the present invention.

The LED 1 is provided, in the lower part 1a thereof, with a series of electrical contacts 5 that are used to connect the LED 1 to an electric circuit. In the lower part 1a the LED 1 also has a heat dissipating element 6, a so-called thermal slug, or thermal pad, made, for example, of a metal material that is a good heat conductor. The heat dissipating element 6 promotes the passage of heat produced by the LED during operation thereof to the substrate 3 of the printed circuit board 2. The heat dissipating element is insulated electrically from the electrical contacts 5.

However, as already said, the layer 4 of electrically insulating material that covers the substrate 3 hinders the aforesaid passage of heat.

According to the present invention, in order to improve heat transmission between the LED 1 and the substrate 3, there is provided removing the material of a part of the electrically insulating layer 4, for example by controlled z-axis milling, at a contact zone 7 between the heat dissipating element 6 and the electrically insulating layer 4, so as to make it possible to make, in said zone, a connection 8 with high thermal conductivity between the heat dissipating element 6 and the substrate 3. The connection with high thermal conductivity can be obtained by welding the heat dissipating element 6 to the substrate 3, with a heat-conducting material as weld material, for example metal material.

Alternatively, the connection between the heat dissipating element 6 and the substrate 3 can be obtained by making a covering with heat-conducting material, for example metal material, on the heat dissipating element 6 and/or on the substrate 3 for example by an electrochemical method or by depositing vapours of said metal material on said heat dissipating element 6 and/or on said substrate 3.

Owing to the connection 8 with high thermal conductivity between the heat dissipating element 6 and the substrate 3 the transmission to the substrate 3 of the heat produced by the LED 1 during operation thereof is greatly improved, which enables the operating temperature of the LED 1 to be noticeably reduced, thus significantly increasing the working life thereof and drastically reducing the risk of faults due to overheating of the LED.

In the practical embodiment, the materials, dimensions and constructional details can be different from those indicated but be technically equivalent thereto.

## Claims

1. Method for improving heat dissipation in systems that use LEDs (1) with high power density mounted on a printed circuit board (2), said LEDs (1) each being provided, on a face (1a) thereof, with a plurality of electrical contacts (5) adapted for connecting electrically the LEDs (1) to conducting tracks made on said board (2), said LEDs (1) being also provided, on said face (1a), with a heat dissipating element (6), said board (2) comprising a substrate (3) made of heat-conducting material, covered by a layer of electrically insulating material (4), on which said conducting tracks are made, said method comprising mounting said LEDs (1) on said board (2) in such a manner that said face (1a) with said heat dissipating element (6) faces said layer (4) of electrically insulating material, **characterised in that** it further comprises the following steps:
- removing the material of a part of said electrically insulating layer (4) at a contact zone (7) between said heat dissipating element (6) of each LED (1) and said electrically insulating layer (4);
- making a heat conducting connection (8) between said heat dissipating element (6) and said substrate (3) in said zone (7).

2. Method according to claim 1, wherein said heat conducting connection (8) is made by using a metal material.

3. Method according to claim 1, or 2, wherein said heat conducting connection (8) is made by welding said heat dissipating element (6) to said substrate (3).

4. Method according to claim 1, or 2, wherein said heat conducting connection (8) is obtained by making a covering of a heat conducting material on said heat dissipating element (6) and/or on said substrate (3).

5. Method according to claim 4, wherein said covering is made by an electrochemical method.

6. Method according to claim 4, wherein said covering is made by deposing vapours of said heat conducting material on said heat dissipating element (6) and/or on said substrate (3).

## Patentansprüche

1. Verfahren zum Verbessern von Wärmedissipation in Systemen, die LEDs (1) mit hoher Leistungsdichte verwenden, die auf einer Leiterplatte (2) angebracht sind, wobei die LEDs (1) jeweils auf einer Seite (1a) derselben mit einer Mehrzahl von elektrischen Kontakten versehen sind, die zum elektrischen Kontaktieren der LEDs mit auf der Platte (2) gefertigten Leiterbahnen angepasst sind, wobei die LEDs (1) außerdem auf der Seite (1a) mit einem Wärme dissipierenden Element (6) versehen sind, wobei die Platte (2) ein Substrat (3) aufweist, dass aus einem wärmeleitfähigen Material gefertigt ist, dass von einer Schicht aus elektrisch isolierendem Material (4) bedeckt ist, auf dem die Leiterbahnen gefertigt sind, wobei das Verfahren ein Anbringen der LEDs (1) auf der Platte (2) derart aufweist, dass die Seite (1a) mit dem Wärme dissipierenden Element (6) der Schicht (4) aus elektrisch isolierendem Material zugewandt ist, **dadurch gekennzeichnet, dass** es weiterhin die folgenden Schritte aufweist:
- Entfernen des Materials eines Teils der elektrisch isolierenden Schicht (4) an einer Berührzone (7) zwischen dem Wärme dissipierenden Element (6) jeder LED (1) und der elektrisch isolierenden Schicht (4);
- Herstellen einer Wärme leitenden Verbindung (8) zwischen dem Wärme dissipierenden Element (6) und dem Substrat (3) in dieser Zone (7).

2. Verfahren nach Anspruch 1, wobei die Wärme leitende Verbindung (8) durch Verwendung eines metallischen Materials hergestellt wird.

3. Verfahren nach Anspruch 1 oder 2, wobei die Wärme leitende Verbindung (8) durch Schweißen des Wärme dissipierenden Elements (6) an das Substrat (3) hergestellt wird.

4. Verfahren nach Anspruch 1 oder 2, wobei die Wärme leitende Verbindung (8) durch Herstellen einer Abdeckung aus einem Wärme leitenden Material auf dem Wärme dissipierenden Element (6) und/oder auf dem Substrat (3) erhalten wird.

5. Verfahren nach Anspruch 4, wobei die Abdeckung durch ein elektrochemisches Verfahren hergestellt wird.

6. Verfahren nach Anspruch 4, wobei die Abdeckung durch Abscheiden von Dämpfen aus dem Wärme leitenden Material auf dem Wärme dissipierenden Element (6) und/oder auf dem Substrat (3) hergestellt wird.

## Revendications

1. Procédé pour améliorer la dissipation thermique dans des systèmes qui utilisent des LED (diodes électroluminescentes) (1) à haute densité de puissance montées sur une carte de circuit imprimé (2), lesdites LED (1) étant pourvues chacune, sur une face (1a) de celles-ci, d'une pluralité de contacts électriques (5) aptes à relier électriquement les LED (1) à des pistes conductrices réalisées sur ladite carte (2), lesdites LED (1) étant également pourvues, sur ladite face (1a), d'un élément de dissipation thermique (6), ladite carte (2) comprenant un substrat (3) réalisé en matériau thermoconducteur, revêtu d'une couche de matériau électriquement isolant (4), sur laquelle lesdites pistes conductrices sont réalisées, ledit procédé consistant à monter lesdites LED (1) sur ladite carte (2) de manière à ce que ladite face (1a) avec ledit élément de dissipation thermique (6) se trouve face à ladite couche (4) de matériau électriquement isolant, **caractérisé en ce qu'**il comprend en outre les étapes suivantes consistant à :
- éliminer le matériau d'une partie de ladite couche électriquement isolante (4) au niveau d'une zone de contact (7) entre ledit élément de dissipation thermique (6) de chaque LED (1) et ladite couche électriquement isolante (4) ;
- réaliser une liaison de conduction thermique (8) entre ledit élément de dissipation thermique (6) et ledit substrat (3) dans ladite zone (7).

2. Procédé selon la revendication 1, dans lequel ladite liaison de conduction thermique (8) est réalisée en utilisant un matériau métallique.

3. Procédé selon la revendication 1, ou 2, dans lequel ladite liaison de conduction thermique (8) est réalisée en soudant ledit élément de dissipation thermique (6) audit substrat (3).

4. Procédé selon la revendication 1, ou 2, dans lequel ladite liaison de conduction thermique (8) est obtenue en réalisant un revêtement d'un matériau conducteur de la chaleur sur ledit élément de dissipation thermique (6) et/ou sur ledit substrat (3).

5. Procédé selon la revendication 4, dans lequel ledit revêtement est réalisé par un procédé électrochimique.

6. Procédé selon la revendication 4, dans lequel ledit revêtement est réalisé en déposant des vapeurs dudit matériau conducteur de la chaleur sur ledit élément de dissipation thermique (6) et/ou sur ledit substrat (3).
